# EUROPEAN PATENT APPLICATION

(11) **EP 1 800 800 A1**
(43) Date of publication of application: **27.06.2007**
(21) Application number: 05765668.8
(22) Date of filing: 13.07.2005
(51) Int. Cl.: B24B 37/00, H01L 21/304

(54) **ABRASIVE PAD**

(30) Priority: 14.10.2004 JP 2004299838
(71) Applicant: Nihon Microcoating Co., Ltd., Akishima-shi, Tokyo 1960021 (JP)
(72) Inventor: Izumi, Toshihiro c/o Nihon Microcoating Co., Ltd., Akishima-shi, Tokyo 1960021 (JP); Tamura, Jun c/o Nihon Microcoating Co., Ltd., Akishima-shi, Tokyo 1960021 (JP); Nagamine, Takuya c/o Nihon Microcoating Co., Ltd., Akishima-shi, Tokyo 1960021 (JP); Arahata, Takashi c/o Nihon Microcoating Co., Ltd., Akishima-shi, Tokyo 1960021 (JP)
(74) Representative: Lerwill, John
(86) International application number: PCT/JP2005/012903
(87) International publication number: WO 2006/040864

(57) **Abstract**

It is therefore an object of this invention to provide a polishing pad capable of planarize the surface of a wafer (or the surface of a device) quickly and uniformly. A polishing pad for planarizing the surface of a wafer has a planar main body of a non-foamed synthetic resin, having Shore D hardness of 66.0-78.5, preferably 70.0-78.5, or more preferably 70.0-78.0, compressibility of 4% or less or preferably 2% or less, and compression recovery rate of 50% or greater or preferably 70% or greater.

## Description

### Technical Field

This invention relates to a polishing pad for polishing a target object such as a semiconductor wafer or a magnetic hard disk substrate that requires a high degree of flatness on the surface and more particularly to such a pad suited for the planarization of wafer surfaces in the production process of semiconductor devices.

### Background of the Art

In the production process for semiconductor devices, the metallic wiring layer for mutually connecting elements such as transistors, capacitors and resistors is coming to be produced in a multi-layer form, and such layers are usually formed by using photolithography or damascene technologies. By the photolithography method, a wiring pattern is exposed to light to produce a multi-layer structure but steps tend to be formed on the surface of the device when an insulating film is placed over a metallic wiring layer, etc. If the surface unevenness of the device due to such steps becomes greater than the depth of focusing at the time of light exposure, the accuracy in the widths and shapes of the pattern is adversely affected and the yield of the semiconductor devices becomes poor as a result. In other words, if the unevenness of the surface unevenness of the device caused by such steps can be reduced, the exposure margin in photolithography can be secured, the minute patterning and etching processes for the wiring layer can be carried out both accurately and easily and hence the yield of semiconductor devices can be improved. By the damascene method, a wiring metal (Cu) is placed after wiring grooves are formed on the insulating film and a multi-layer structure is obtained by leaving the metal only inside the groove by a polishing process but there remains the so-called problem of "dishing" whereby the center part of the metal is made too thin by the polishing process. For this reason, planarization of the device surface is very important in the production process of semiconductor devices.

Planarization is done by chemical mechanical polishing (CMP). CMP is a polishing technology combining both a chemical operation by using a fabrication liquid and a mechanical removal operation by using abrading particles whereby the device surface is chemically melted by the fabrication liquid and mechanically polished by the abrading particles, and it is widely being used because unwanted parts different from the internal parts are hardly formed on the surface by the process.

Planarization by CMP is carried out by rotating a lapping plate (or a platen) with a polishing pad attached thereto, supplying slurry having small particles of a material selected from the group consisting of silica, alumina, ceria and zirconia dispersed in an alkaline or acidic fabrication liquid on the surface of the polishing pad, and pressing thereto the surface of the wafer (or the surface of the device) attached to a polishing head (or a carrier).

A polishing pad of a foamed material such as polyurethane having many air holes formed by air bubbles at the time of foaming is usually used (such as IC1000 (product name) produced by Rohm and Haas Electronic Materials CMP Holdings Incorporated).

Since foamed pads are easily compressive and deformable, however, they tend to cause remnant steps by becoming deformed and entering indentations on the device surface and abrading the interiors of the indentations during the planarization process. Moreover, since there are fluctuations in the air hole density inside a foamed pad, although the wafer surface is uniformly pressed onto the pad surface, the repulsive force of the pad against this compressive force becomes non-uniform. Thus, the surface of the pad cannot operate on the wafer surface uniformly and the wafer surface cannot be polished uniformly. As a result, fluctuations appear in the stock removal within the polished wafer surface.

For this reason, Reference 1, for example, proposed the use of a pad produced by hardening a synthetic resin such as polyurethane without foaming (hereinafter referred to as non-foamed pad). Since non-foamed pads are hard to compress (having a low compressibility) and slow in recovering from a deformed condition under compression (having a small elastic repellent force), they do not easily enter and abrade the interiors of the indentations on the device surface and hence the generation of remnant steps can be reduced. Since the polishing rate is significantly lower with non-foamed pads than with foamed pads, grooves are commonly formed on the pad surface so as to improve the polishing rate.
Reference 1: Japanese Patent Laying-open No. 2004-507077

### Disclosure of the Invention

### Problem(s) to be solved by the Invention

The polishing rate of a non-foamed pad cannot be improved to be nearly the same as that of a foamed pad, however, merely by forming a pattern of grooves on the pad surface.

Although non-foamed pads were considered capable of uniformly applying their elastic repellent force to the pad surface because there are no air holes formed inside, furthermore, this has turned out not to be the case because, since non-foamed pads have a slow compression recovery rate and are slow in recovering from the compressed condition, there are fluctuations in the elastic repellent force within the surface and a uniform force cannot be applied onto the wafer surface.

It is therefore an object of this invention to provide a polishing pad capable of planarize the surface of a wafer (or the surface of a device) quickly and uniformly.

### Means for solving the problem(s)

As described above, it used to be believed regarding polishing pads of a non-foamed material that fluctuations in stock removal increase over the surface of the target object if the compression recovery rate is reduced and that the elastic repellent force increases and remnant steps come to result if the compression recovery rate is made too large. The present inventors have discovered, however, the appearance of remnant steps can be reduced and the target surface can be polished quickly and made uniformly smooth by using a polishing pad of a non-foamed material with a high compression recovery rate and a low compressibility if its hardness is appropriately selected.

Thus, a polishing pad according to this invention is characterized as comprising a planar pad main body of a non-foamed synthetic resin.

The planar pad main body has Shore D hardness of 66.0-78.5, or preferably 70.0-78.5, or more preferably 70.0-78.0, or even more preferably 72.0-76.0.

The planar pad main body has compressibility of 4% or less, or preferably 2% or less.

The planar pad main body has compression recovery rate of 50% or greater, or preferably 70% or greater.

In order to suppress the occurrence of the hydroplane phenomenon, grooves may be formed on the surface of the pad main body. The surface ratio of the grooves (or the ratio of the percentage of the surface area covered by the grooves) may be 10%-50%.

In order to improve the ability of the pad to follow the surface contour of the target object, a backing sheet having Shore D hardness greater than that of the pad main body and compressibility higher than that of the pad main body may be affixed to the back surface of the pad main body.

The pad main body may be transparent. According to a preferred embodiment of the invention, the pad main body has thickness 0.5mm - 2.0mm and transmissivity of 10% or greater to light with wavelength of 350nm-900nm, and preferably 30% or greater to light with wavelength of 450nm-900nm.

### Effect(s) of the Invention

With a polishing pad structured as above, a wafer surface can be polished quickly and smoothly without causing fluctuations in stock removal by reducing remnant steps.

### Best Mode for carrying out the Invention

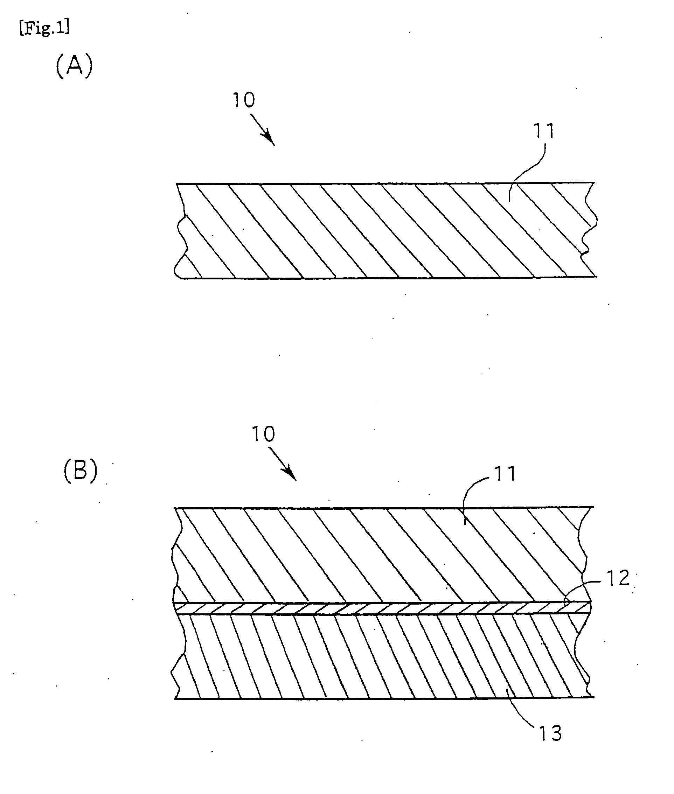

As shown in Fig. 1A, a polishing pad 10 of this invention comprises a sheet-like pad main body 11.

The pad main body 11 is formed of a non-foamed thermoplastic or thermosetting synthetic resin selected from the group consisting of polyester resins, polyurethane resins, polypropylene resins, nylon resins, acryl resins and epoxy resins.

The pad main body 11 may be produced by placing a resin solution prepared by adding a hardener to a synthetic resin material in a mold, hardening it inside the mold to form a non-foamed block and slicing it into a desired thickness. Any known method of sheet molding such as extrusion molding and jet molding may be used.

There is no stringent limitation as to the thickness but it may preferably be within the range of 0.5mm-2.0mm.

The Shore D hardness (as measured by a Shore D hardness meter according to JIS-L-1096) obtained under the temperature condition of 23±3°C is in the range of 66.0-78.8, preferably in the range of 70.0-78.8 and even more preferably in the range of 72.0-76.6. The polishing pressure when the polishing pad 10 of this invention is used (as will be explained below more in detail) is rarely over 15psi, being preferably in the range of below 15psi and more preferably in the range of 1psi - 10psi. If the Shore D hardness of the pad main body 11 is less than 66.0 when the pressure is less than 15psi, the pad main body 11 tends to become deformed excessively, increasing the fluctuations in the stock removal over the wafer surface such that the wafer surface cannot be polished uniformly. If the Shore D hardness of the pad main body exceeds 78.5, on the other hand, it is not sufficiently deformable and its ability to follow the surface contour becomes low, tending to cause scratches on the surface of the target object being polished.

Compressibility is the ratio of change in the thickness of the pad main body 11 as the load is changed from 1.4psi (the standard) to 16psi under the temperature condition of 23±3°C. According to this invention, compressibility of the pad main body 11 is 4% or less, and preferably 2% or less. If compressibility exceeds 4%, the interiors of the surface indentations of the wafer are abraded excessively, causing remnant steps.

Compression recovery rate is measured as the change in the displacement of the pad main body 11 with a load of 16psi under the temperature condition of 23±3°C. After the load is reduced to 1.6psi, the displacement by recovering the thickness in 30 seconds is measured and this measured displacement is divided by the displacement with the load of 16psi. According to this invention, the compression recovery rate of the pad main body 11 is 50% or over, and preferably 70% or over. If the compression recovery rate is less than 50%, the unevenness on the device surface cannot be followed sufficiently well, and fluctuations result in the elastic repellent force of the pad over the wafer surface such that the wafer surface cannot be polished uniformly.

Grooves may be formed on the surface of the pad main body 11 in order to prevent adsorption of the wafer and to reduce the possibility of occurrence of the so-called hydroplane phenomenon. The ratio of surface area where grooves are formed (by considering the surface of the pad main body 11 to be a flat plane) with respect to the whole area of the pad main body 11 is in the range of 10%-50%. The grooves may be concentric circles or in a lattice formation. They may be any combination of straight and curved lines in any geometrical pattern.

Fig. 1B shows another polishing pad 10 according to this invention having a backing sheet 13 attached to the back surface of a main body 11 by means of an adhesive 12 for improving its ability to follow the contour of the target object to be polished. The backing sheet 13 may be an elastic sheet harder than the main body 11 and having a compressibility lower than that of the main body 11. A sheet of a foamed substance comprising polyurethane may be used as the backing sheet 13.

<Embodiment> Polishing process using a polishing pad of this invention is explained next. As explained above about the production of a semiconductor device, steps are formed on the surface of a wafer if an insulating film is formed on a metallic wiring formed on the wafer.

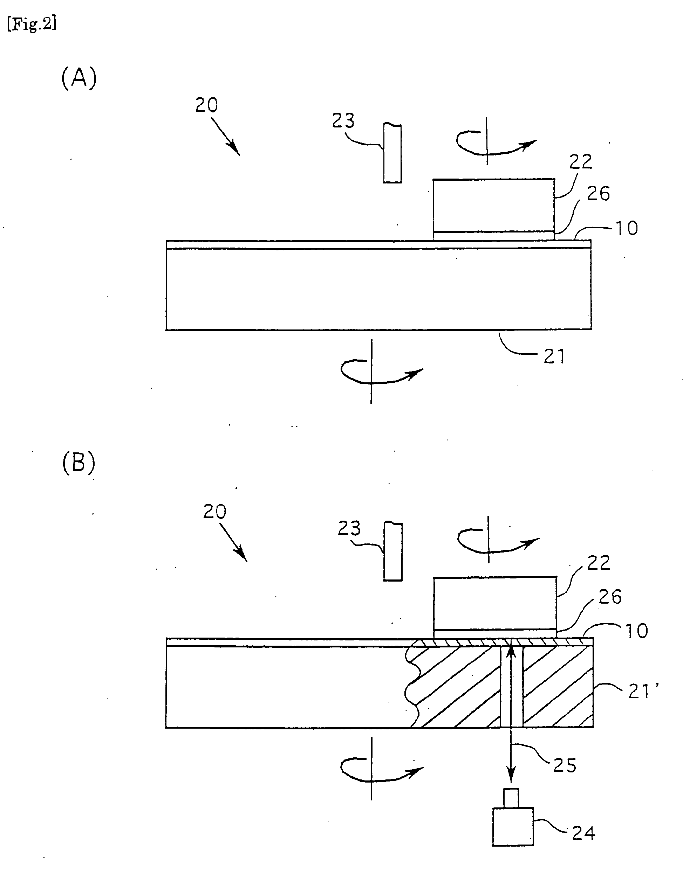

Such steps are removed in order to planarize the wafer surface according to this invention by using a CMP polishing machine as shown in Figs. 2A and 2B.

As shown in Fig. 2A, the pad 10 is attached to the surface of a lapping plate (or platen) 21 by means of an adhesive tape and the lapping plate 21 is rotated. Slurry is supplied through a nozzle 23 to the surface of the polishing pad 10 and the surface of the wafer 26 attached to a polishing head (or a carrier) 22 is pressed against the surface of the polishing pad and rotated.

Fig. 2B shows another polishing technology (called the end point detection polishing) whereby light is applied to the surface of the wafer being polished for detecting the end point of the polishing. The polishing pad 10 is attached to the surface of a lapping plate (or platen) 21' by means of an adhesive tape and the lapping plate 21' is rotated. Slurry is supplied through a nozzle 23 to the surface of the polishing pad 10 and the surface of the wafer 26 attached to a polishing head (or a carrier) 22 is pressed against the surface of the polishing pad and rotated. During the polishing process, light 25 from a light source 24 is applied to the surface of the wafer 26 through a throughhole provided through the lapping plate 21' and the reflected light 25 is received by a monitor 24 for detecting the end point of the polishing to complete the polishing process.

When the technology shown in Fig. 2B is used, a polishing pad with the pad main body 11 made of a transparent material is used. If the thickness of the pad main body 11 is within the range of 0.5mm - 2.0mm, its light transmissivity (for light in frequency range of 350nm - 900nm) is 10% or over. Preferably, the light transmissivity for light in frequency range of 450nm - 900nm is 30% or over when the thickness of the pad main body 11 is 0.5mm - 2.0mm.

Although not shown, the CMP devices of Figs. 2A and 2B may be provided with a retainer ring on the polishing head 22 around the wafer which serves to press the polishing pad by the pressure applied to the annular portion for preventing excessive polishing that is likely to take place along the periphery of the wafer and also to prevent the wafer from becoming displaced by the transverse force which is generated during the polishing process. The polishing head 22 is caused to undergo a reciprocating swinging motion in the radial direction of the lapping plate 21 or 21' in order to alleviate the effects of the grooving work during the polishing process.

The polishing devices 20 shown in Figs. 2A and 2B may be further provided with dressing tools such as a diamond dresser for removing diamond debris generated during the polishing process clogging the surface of the polishing pad 10 or scraping off deformed portions on the surface caused by friction. The dressing work may be carried out by supplying water on the surface of the polishing pad 10 pasted on the surface of the rotating lapping plate 21 or 21' and pressing the dressing tool.

Slurry is obtained by dispersing abrading particles in water or a water-based aqueous solution and further adding a reactive liquid capable of chemically reacting with the wafer surface such as sodium hydroxide and ammonia.

The pressure (or the polishing pressure) with which the wafer 26 is pressed to the surface of the polishing pad 10 (or the surface of the pad main body 11) is within the range of 1psi - 10psi.

The invention is described next by way of test and comparison examples.

### <Test Example 1>

A resin solution was prepared by adding 26.5 parts of 3,3'-dichrol-4,4'-diamino-diphenyl methane as hardener to 100 parts of TDI (trilene diisocyanate) type urethane prepolymer with average molecular weight of about 750. This resin solution was placed inside a mold and hardened inside this mold to obtain a non-foamed block. This block was sliced into a thickness of 1.5mm to produce pad main bodies with Shore D hardness of 78.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Test Example 1.

### <Test Example 2>

A resin solution was prepared by adding 26.5 parts of 3,3'-dichrol-4,4'-diamino-diphenyl methane as hardener to 100 parts of TDI type urethane prepolymer with average molecular weight of about 900. This resin solution was placed inside a mold and hardened inside this mold to obtain a non-foamed block. This block was sliced into a thickness of 1.5mm to produce pad main bodies with Shore D hardness of 75.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Test Example 2.

### <Test Example 3>

A resin solution was prepared by adding 26.3 parts of 3,3'-dichrol-4,4'-diamino-diphenyl methane as hardener to 100 parts of TDI type urethane prepolymer with average molecular weight of about 960. This resin solution was placed inside a mold and hardened inside this mold to obtain a non-foamed block. This block was sliced into a thickness of 1.5mm to produce pad main bodies with Shore D hardness of 72.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Test Example 3.

### <Test Example 4>

A resin solution was prepared by adding 26.0 parts of 3,3'-dichrol-4,4'-diamino-diphenyl methane as hardener to 100 parts of TDI (trilene diisocyanate) type urethane prepolymer with average molecular weight of about 1080. This resin solution was placed inside a mold and hardened inside this mold to obtain a non-foamed block. This block was sliced into a thickness of 1.5mm to produce pad main bodies with Shore D hardness of 66.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Test Example 2.

### <Comparison Example 1>

A resin solution was prepared by adding 47.3 parts of 3,3'-dichrol-4,4'-diamino-diphenyl methane as hardener to 100 parts of HDI (hexamethylene diisocyanate) type urethane prepolymer. This resin solution was placed inside a mold and hardened inside this mold to obtain a non-foamed block. This block was sliced into a thickness of 1.5mm to produce pad main bodies with Shore D hardness of 80.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Comparison Example 1.

### <Comparison Example 2>

A resin solution was prepared by adding 23.0 parts of 3,3'-dichrol-4,4'-diamino-diphenyl methane as hardener to 100 parts of TDI type urethane prepolymer with average molecular weight of about 1260. This resin solution was placed inside a mold and hardened inside this mold to obtain a non-foamed block. This block was sliced into a thickness of 1.5mm to produce pad main bodies with Shore D hardness of 60.0 (at measurement temperature of 23.0°C). Grooves (of spiral shape with land width 0.6mm and groove width 0.3mm and groove occupancy ratio of 33.3%) were formed on the surfaces of these pad main bodies by means of a lathe to produce polishing pads of Comparison Example 2.

### <Comparison Example 3>

Commercially available polishing pads of a foamed material (IC100 produced by Rohm and Haas Electronic Materials CMP holdings Incorporated) were used as polishing pads of Comparison Example 3. Their thickness was 1.23mm and Shore D hardness was 59.0.

Shore D hardness, compression ratio and compression recovery rate of the polishing pads of Test Examples 1-4 and Comparison Examples 1-3 are summarized in Table 1.

### [Table 1]

**Table 1**

| | Shore D hardness | Compressibility (%) | Compression recovery rate (%) |
|---|---|---|---|
| Test Example 1 | 78.0 | 0.79 | 80.0 |
| Test Example 2 | 75.0 | 0.84 | 80.2 |
| Test Example 3 | 72.0 | 0.85 | 80.4 |
| Test Example 4 | 66.0 | 0.87 | 79.8 |
| Comparison Example 1 | 80.0 | 0.79 | 80.1 |
| Comparison Example 2 | 60.0 | 0.82 | 79.8 |
| Comparison Example 3 | 59.0 | 4.05 | 19.5 |

### <Comparison Test 1>

Polishing pads of Test Example 3 and Comparison Example 3 were used to polish the surfaces of wafers and the steps on the wafer surfaces were examined for each pad.

Well known test wafers (SKW7-2) commonly used for evaluating planarization were used. These are wafers produced by using a specified mask pattern to etch the surface of silicon substrates and having a silicon oxide film vapor-deposited by a CVD process. In Comparison Test 1, steps of Patterns D20, D40 and D80 were compared with Pattern D100 on test wafers each polished by using a different polishing pad. In the above, Pattern D100 is the portion of a test wafer with no unevenness. Pattern D20 is the portion having straight line protrusions with width 20µm and straight line indentations with width 80µm and depth 0.8µm formed alternately. Pattern D40 is the portion having straight line protrusions with width 40µm and straight line indentations with width 60µm and depth 0.8µm formed alternately. Pattern D80 is the portion having straight line protrusions with width 80µm and straight line indentations with width 20µm and depth 0.8µm formed alternately. Unevenness on the wafer surfaces was measured by using a commercially available apparatus for the measurement of steps (P-1 (product name) produced by Tencor Inc.)

For the polishing, a commercially available polishing machine as shown in Fig. 2A (MAT-ARW681S (product name) produced by MAT, Inc) was used under conditions as shown in Table 2. As for the slurry, a commercially available slurry liquid (Semi Sperse 25 (product name) produced by Cabot Microelectronics Japan, Inc.) was diluted with pure water at 1:1 and used.

### [Table 2]

**Table 2**

| | |
|---|---|
| Rotational speed of lapping plate | 60 rpm |
| Rotational speed of polishing head | 63 rpm |
| Polishing load (polishing pressure) | 3 psi |
| Load on retainer ring | 5 psi |
| Speed of swinging reciprocating motion | 1mm/minute |
| Distance of swinging reciprocating motion | 10mm |
| Slurry flow rate | 200cc/minute |

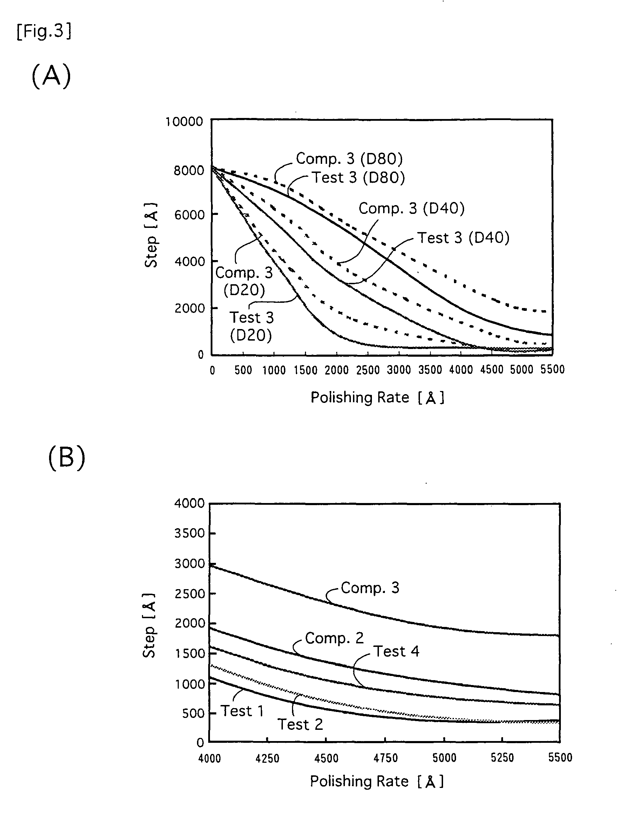

The results of Comparison Test 1 are shown in Fig. 3A. They clearly show regarding each of the patterns D20, D40 and D80 that a smoother surface can be obtained more quickly if a pad according to Test Example 3 is used than if a pad according to Comparison Example 3 is used.

### <Comparison Test 2>

Polishing pads of Test Examples 1, 2 and 4 and Comparison Examples 2 and 3 were each used to polish a wafer surface as done in Comparison Test 1.

In Comparison Test 2, as similar to Comparison Test 1, well known test wafers (SKW7-2) commonly used for evaluating planarization were used. In Comparison Test 2, steps of Pattern D80 were compared with Pattern D100.

For the polishing, a commercially available polishing machine as shown in Fig. 2A (MAT-ARW681S (product name) produced by MAT, Inc) was used under conditions as shown in Table 2. As for the slurry, a commercially available slurry liquid (Semi Sperse 25 (product name) produced by Cabot Microelectronics Japan, Inc.) was diluted with pure water at 1:1 and used.

The results of Comparison Test 2 are shown in Fig. 3B. They clearly show regarding Pattern D80 that a smoother surface can be obtained more quickly if a pad according to Test Example 1, 2 or 4 is used than if a pad according to Comparison Example 2 or 3 is used.

### <Comparison Test 3>

Polishing pads of Test Examples 1, 2 and 4 and Comparison Examples 1-3 were each used to polish the surface of a wafer with a PTEOS film (with diameter 200mm) having a plasma oxide film (with thickness 10000Å) formed on the surface without any pattern. The results were compared regarding stock removal and WIWNU ("WithIn Wafer Non-Uniformity") for each pad. In the above, WIWNU is a parameter showing fabrication uniformity within the wafer surface and expressed in terms of percentage of (standard deviation in stock removal within the wafer surface)/(average stock removal). A smaller WIWNU value indicates a smaller fluctuation in stock removal. Film thickness was measured for the measurement of stock removal by using a commercially available light interference type apparatus for measurement of film thickness (Nanospec9200 (product name) produced by Nanometrics, Inc.)

For the polishing, a commercially available polishing machine as shown in Fig. 2A (MAT-ARW681S (product name) produced by MAT, Inc) was used under conditions as shown in Table 3. As for the slurry, a commercially available slurry liquid (Semi Sperse 25 (product name) produced by Cabot Microelectronics Japan, Inc.) was diluted with pure water at 1:1 and used.

### [Table 3]

**Table 3**

| | |
|---|---|
| Rotational speed of lapping plate | 60 rpm |
| Rotational speed of polishing head | 63 rpm |
| Polishing load (polishing pressure) | 3 psi |
| Load on retainer ring | 5 psi |
| Speed of swinging reciprocating motion | 1mm/minute |
| Distance of swinging reciprocating motion | 10mm |
| Polishing time | 120 seconds |
| Slurry flow rate | 200cc/minute |

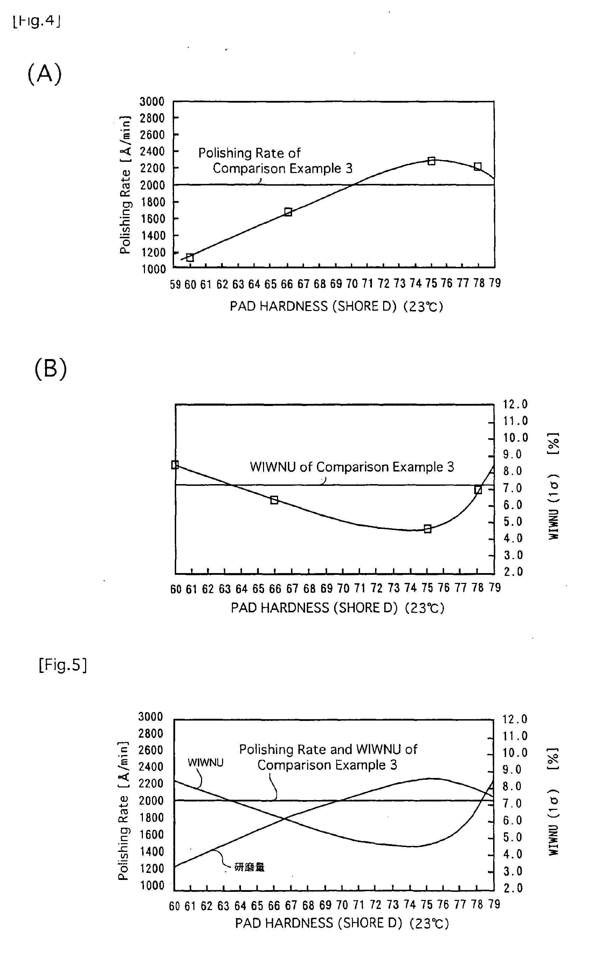

The results of Comparison Test 3 are shown in Table 4. Each number shown in Fig. 4 indicates a value based on a measurement made from the center part to the edge end (5mm) of the wafer. Measured values are shown in Figs. 4A and 4B. Figs. 4A and 4B are shown in a combined form as Fig. 5.

### [Table 4]

**Table 4**

| Shore D hardness (Example) | 60.0 (Comparison 2) | 66.0 (Test 4) | 75.0 (Test 2) | 78.0 (Test 1) | 80.0 (Comparison 1) |
|---|---|---|---|---|---|
| Polishing rate (Å /min) | 1183 | 1702 | 2265 | 2190 | 1900 |
| WIWNU (%) | 8.4 | 6.3 | 4.8 | 7.0 | 10.0 |

| | | | | | |
|---|---|---|---|---|---|
| Polishing rate of Comparison Example 3 was 2000 Å /min and its WIWNU was 7.2%. | | | | | |

The value which is required to be practical value is 1700 Å /min for polishing rate and 8.0% or less for WIWNU.

As shown in Figs. 4 and 5, values of polishing rate and WIWNU required to be practical can be obtained with polishing pads with Shore D hardness within the range of 66.0-78.5.

Fig. 4A shows that the polishing rate is higher than Comparison Example 3 if Shore D hardness is greater than 70.0. In other words, it can be concluded within the hardness range of 70.0 - 78.5 that the aforementioned requirements to be practical are satisfied and also that the polishing rate is higher than Comparison Example 3.

Fig. 4B shows that the WIWNU is lower than Comparison Example 3 within the hardness range of 64.0-78.0. It can thus be concluded within the hardness range of 70.0-78.0 that the aforementioned requirements to be practical are satisfied and that the polishing rate is higher and the WIWNU is lower than Comparison Example 3. The lowest WIWNU value is obtained in the hardness range of 72.0-76.0.

### Brief Description of the Drawings

[Fig.1] Figs. 1A and 1B are each a sectional view of a polishing pad embodying this invention.
[Fig.2] Figs. 2A and 2B show polishing machines.
[Fig.3] Figs. 3A and 3B, together referred to as Fig. 3, show the results of Comparison Tests 1 and 2, Fig. 3A showing the steps in Test Example 3 and Comparison Example 3 and Fig. 3B showing the steps in Test Examples 1, 2 and 4 and Comparison Examples 2 and 3.
[Fig.4] Fig. 4A and 4B, together referred to as Fig. 4, show the results of Comparison Test 4.
[Fig.5] Fig. 5 is a combination of Figs. 4A and 4B.

### Numeral(s)

10 ... a polishing pad
11 ... a pad main body
12 ... an adhesive
13 ... a backing sheet
20 ... CMP machine
21, 21' ... a lapping plate
22 ... a polishing head
23 ... a nozzle
24 ... a monitor
25 ... a reflected light
26 ... a wafer

## Claims

1. A polishing pad comprising a planar pad main body of a non-foamed synthetic resin, said pad main body having Shore D hardness of 66.0-78.5, compressibility of 4% or less and compression recovery rate of 50% or greater.

2. The polishing pad of claim 1 wherein said pad main body has compressibility of 2% or less.

3. The polishing pad of claim 1 wherein said pad main body has compression recovery rate of 70% or greater.

4. The polishing pad of claim 1 wherein said pad main body has Shore D hardness of 70.0-78.5.

5. The polishing pad of claim 1 wherein said pad main body has Shore D hardness of 70.0-73.0.

6. The polishing pad of claim 1 wherein said pad main body has Shore D hardness of 72.0-76.0.

7. The polishing pad of claim 1 wherein said pad main body has thickness 0.5mm - 2.0mm and transmissivity of 10% or greater to light with wavelength of 350nm-900nm.

8. The polishing pad of claim 1 wherein said pad main body has thickness 0.5mm - 2.0mm and transmissivity of 30% or greater to light with wavelength of 450nm-900nm.

9. The polishing pad of claim 1 wherein said pad main body has a surface with grooves over 10%-50% of said surface.

10. The polishing pad of claim 1 further comprising a backing sheet affixed to the back surface of said pad main body.

11. The polishing pad of claim 10 wherein said backing sheet has Shore D hardness greater than that of said pad main body and compressibility higher than that of said pad main body.
